# EUROPEAN PATENT APPLICATION

(11) **EP 4 807 786 A1**
(43) Date of publication of application: **16.09.2026**
(21) Application number: 24902489.4
(22) Date of filing: 18.11.2024
(51) Int. Cl.: H01L 21/66, G01B 21/00, H01L 21/67

(54) **TESTING DEVICE, AND TESTING METHOD FOR SEMICONDUCTOR CLEANING APPARATUS**

(30) Priority: 14.12.2023 CN 202311723795
(71) Applicant: Beijing NAURA Microelectronics Equipment Co., Ltd., Beijing 100176 (CN)
(72) Inventor: GAO, Shaofei, Beijing 100176 (CN); MA, Hongshuai, Beijing 100176 (CN); ZHAO, Hongyu, Beijing 100176 (CN); WANG, Ruiting, Beijing 100176 (CN); ZHANG, Jinbin, Beijing 100176 (CN); ZHANG, Huwei, Beijing 100176 (CN); CHEN, Haixiang, Beijing 100176 (CN)
(74) Representative: Cohausz & Florack
(86) International application number: PCT/CN2024/132570
(87) International publication number: WO 2025/124067

(57) **Abstract**

The present disclosure provides a testing device, and a testing method for a semiconductor cleaning apparatus, and relates to the field of semiconductor technology. Wafer jumping can be detected based on the testing device, adoption of manual visual inspection can be avoided, detection accuracy of wafer jumping can be improved, a wafer can be prevented from being scratched and broken, and an etching effect can also be improved. The testing device includes: a testing balance mechanism, an elastic assembly, and a testing assembly, and two ends of the elastic assembly are connected to the testing balance mechanism and the testing assembly, respectively; one end of the testing balance mechanism is connected to the elastic assembly, and the other end of the testing balance mechanism is configured to support a wafer to be cleaned in a process tank; the testing balance mechanism is configured to change, in a case where the wafer to be cleaned jumps, a deformation amount of the elastic assembly based on the lever principle; and the testing assembly is configured to measure the deformation amount of the elastic assembly.

## Description

### TECHNICAL FIELD

The present disclosure relates to the field of semiconductor technology, and in particular, to a testing device, and a testing method for a semiconductor cleaning apparatus.

### BACKGROUND

A cleaning process is indispensable in a manufacturing process of semiconductor wafers. A cleaning apparatus adopted in the cleaning process includes a wet etching apparatus such as a hot phosphoric acid cleaning apparatus for removing a silicon nitride film layer and a silicon oxynitride film layer, but the hot phosphoric acid cleaning apparatus is relatively complex and hard to control. The hot phosphoric acid cleaning apparatus adopts a hot phosphoric acid etching solution. In a hot phosphoric acid etching process, if the hot phosphoric acid etching solution boils, a wafer is caused to shake and thus collides with a lifter, so that the wafer can be easily scratched or broken. Therefore, the hot phosphoric acid etching solution needs to be kept in a non-boiling state. Since a boiling point of the hot phosphoric acid etching solution is related to phosphoric acid concentration, the phosphoric acid concentration needs to meet corresponding requirements in order to avoid the boiling phenomenon. Meanwhile, in order to improve an etching effect, phosphoric acid volume fraction needs to be kept within a certain range. During an etching process, moisture contained in the phosphoric acid etching solution keeps volatizing with a temperature rise, which changes the phosphoric acid volume fraction and further affects an etching rate. Therefore, intermittent water replenishment to the phosphoric acid etching solution is needed for balancing the water consumed by evaporation and reaction.

At present, manual visual inspection is adopted to determine whether the wafer jumps after water replenishment, so as to determine whether a water replenishment amount meets requirements. However, due to differences in individual perception, tiny jumps are hard to identify; in addition, an operator needs to wear special and heavy protective clothing and protective glasses under process conditions, and vapors generated by evaporation of the hot phosphoric acid etching solution seriously obstruct the view, and thus hinder observation of wafer jumping by the operator. Therefore, accuracy of detecting wafer jumping with the manual visual inspection is not high, which affects control of the water replenishment amount. As a result, on the one hand, the wafer can be easily scratched and broken; on the other hand, the etching effect is affected.

### SUMMARY

Embodiments of the present disclosure provide a testing device, and a testing method for a semiconductor cleaning apparatus. Wafer jumping can be detected based on the testing device, adoption of manual visual inspection can be avoided, and detection accuracy of wafer jumping can be improved, thereby preventing a wafer from being scratched and broken while improving an etching effect.

In order to achieve the above objectives, the embodiments of the present disclosure adopt the following technical solutions.

In one aspect, an embodiment of the present disclosure provides a testing device applied to a semiconductor cleaning apparatus, the semiconductor cleaning apparatus includes a process tank, and a wafer to be cleaned is disposed in the process tank; the testing device includes: a testing balance mechanism, an elastic assembly, and a testing assembly, and two ends of the elastic assembly are connected to the testing balance mechanism and the testing assembly, respectively; and the testing balance mechanism, the elastic assembly, and the testing assembly are configured to form a lever system together with the wafer to be cleaned;
one end of the testing balance mechanism is connected to the elastic assembly, and the other end of the testing balance mechanism is configured to support the wafer to be cleaned in the process tank;
the testing balance mechanism is configured to change, in a case where the wafer to be cleaned jumps, a deformation amount of the elastic assembly based on the lever principle; and
the testing assembly is configured to measure the deformation amount of the elastic assembly.

In some embodiments, the testing balance mechanism includes: a rotatable assembly and a testing balance assembly;
the test balancing assembly includes a first part and a second part; one end of the first part is fixedly connected to the second part, and the other end of the first part is disposed in the process tank for supporting the wafer to be cleaned; and an end of the second part which is not connected to the first part is connected to the elastic assembly;
the rotatable assembly is connected at a connection position of the first part and the second part, and a contact point of the rotatable assembly with the connection position is a fixed point;
the first part is configured to rotate around the fixed point in a case where the wafer to be cleaned jumps;
the rotatable assembly is configured to be driven by the first part to rotate around an axis of the rotatable assembly; and
the second part is configured to be driven by the first part and the rotatable assembly to rotate around the fixed point, so as to change the deformation amount of the elastic assembly.

In some embodiments, the first part includes a power rod, a connecting rod, and a support member, which are connected in sequence; the support member includes a base and a supporting part disposed on the base, the base is connected to the connecting rod, and the supporting part is configured to support the wafer to be cleaned; and a first included angle is formed between the power rod and the connecting rod, and a second included angle is formed between the connecting rod and the base; and
the second part includes a resistance rod; and the resistance rod has one end connected to the power rod and the other end connected to the elastic assembly.

In some embodiments, the power rod and the resistance rod are integrally formed.

In some embodiments, the first included angle and/or the second included angle is 90 degrees.

In some embodiments, the testing device further includes: a supporting portion and a fixing plate; and
the supporting portion is fixed to the fixing plate, and includes a supporting surface and a fixing surface which are opposite to each other, the fixing surface is in contact with the fixing plate, and the supporting surface is configured to support the testing balance mechanism.

In some embodiments, the elastic assembly includes a spring, and the testing assembly includes a load cell.

In some embodiments, the testing assembly further includes a chute, and the load cell is movable along the chute before a mounting position is determined; after the mounting position is determined, the load cell is fixed to the chute; and the mounting position is a location of the load cell in a case where the testing balance mechanism supports the wafer to be cleaned in the process tank and the lever system is in a balanced state.

In the other aspect, an embodiment of the present disclosure provides a testing method for a semiconductor cleaning apparatus, wherein the semiconductor cleaning apparatus includes a lifter and a process tank; the testing method for the semiconductor cleaning apparatus includes:
carrying a wafer to be cleaned and moving the wafer to be cleaned in the process tank by the lifter;
adjusting a position of the testing assembly of the above testing device to enable the testing balance mechanism of the testing device to replace the lifter to support the wafer to be cleaned;
performing a plurality of sets of concentration ratio tests on a chemical solution in the process tank, each set of concentration ratio tests including at least one chemical solution concentration ratio test; and
based on recorded results of the plurality of sets of concentration ratio tests, selecting a water replenishment amount which meets conditions that the wafer to be cleaned does not jump after water replenishment and a concentration of the chemical solution in the process tank is within an ideal concentration range after water replenishment, wherein the recorded results include each water replenishment amount, jumping situations of the wafer to be cleaned after water replenishment, and concentration values of the chemical solution in the process tank after water replenishment;
wherein the at least one chemical solution concentration ratio test includes:
   replenishing water to the process tank under the condition that a water replenishment condition is met;
   determining whether the wafer to be cleaned jumps based on a test value from the testing assembly of the testing device after current water replenishment;
   determining a test step after the current water replenishment based on a determination result, the test step after the current water replenishment including any one of a step of ending the current test, a step of performing a next chemical solution concentration ratio test, or a step of replacing the chemical solution in the process tank and performing a next set of concentration ratio tests; and
   recording a current water replenishment amount, a jumping situation of the wafer to be cleaned after the current water replenishment, and a concentration value of the chemical solution in the process tank after the current water replenishment.

In some embodiments, replenishing the water to the process tank under the condition that the water replenishment condition is met includes:
in response to a difference between an ideal concentration of the chemical solution in the process tank and an actual concentration of the chemical solution in the process tank being within a range of a preset concentration difference, replenishing the water to the process tank.

In some embodiments, determining whether the wafer to be cleaned jumps based on the test value from the testing assembly of the testing device after the current water replenishment includes:
determining a difference between an absolute value of a percentage change A1 in the test value from the testing assembly after the current water replenishment and a preset percentage change A2, wherein A1 = [(A - A0) / A0]×100%, where A denotes the test value from the testing assembly of the testing device after the current water replenishment, and A0 denotes a test value from the testing assembly of the testing device before the current water replenishment; and
in response to the difference being greater than or equal to zero, determining that the wafer to be cleaned jumps; and in response to the difference being less than zero, determining that the wafer to be cleaned does not jump.

In some embodiments, determining the test step after the current water replenishment based on the determination result includes:
in response to a case where the wafer to be cleaned does not jump after the current water replenishment and a number of times of completed water replenishment does not reach a preset number of times of water replenishment, performing the next chemical solution concentration ratio test after a preset time period;
or in response to a case where the wafer to be cleaned does not jump after the current water replenishment and a number of times of completed water replenishment reaches a preset number of times of water replenishment, ending the current test;
or in response to a case where the wafer to be cleaned jumps after the current water replenishment, replacing the chemical solution in the process tank, and performing the next set of concentration ratio tests; wherein the current chemical solution concentration ratio test is an i^{th} chemical solution concentration ratio test in a current set of concentration ratio tests, a water replenishment amount of the i^{th} chemical solution concentration ratio test in the current set of concentration ratio tests is larger than a water replenishment amount of an i^{th} chemical solution concentration ratio test in the next set of concentration ratio tests, and i is a positive integer and meets 1≤i<the preset number of times of water replenishment.

The embodiments of the present disclosure provide the testing device, a semiconductor cleaning system, and the testing method for a semiconductor cleaning apparatus. In the testing device, jumping of the wafer to be cleaned is converted into measurable deformation of the elastic assembly by cooperation of the testing balance mechanism, the elastic assembly, and the testing assembly, so that whether the wafer to be cleaned jumps can be determined from a change of test data from the testing assembly. In this way, adoption of manual visual inspection can be avoided, so that personal safety issues can be prevented, and a risk factor can be reduced. In addition, the testing device is free from vapors in a process environment, and can greatly improve detection accuracy and efficiency of wafer jumping, thereby preventing the wafer from being scratched and broken, reducing wafer breakage rate, and also improving the etching effect.

The above description is just a summary of the technical solutions of the present disclosure. Implementations of the present disclosure are described below for enabling the technical means of the present disclosure to be understood clearly to be implemented according to the specification and making the above and other objectives, features and advantages of the present disclosure obvious and intelligible.

### BRIEF DESCRIPTION OF DRAWINGS

The drawings for the description of the embodiments or the related technology will be briefly described below. Apparently, the drawings described below are only for some embodiments of the present disclosure, and other drawings can be derived by those of ordinary skill in the art from the drawings described below without any inventive work.
FIG. 1 is a schematic structural diagram of a testing device according to an embodiment of the present disclosure;
FIG. 2 is a schematic structural diagram of a testing balance mechanism according to an embodiment of the present disclosure;
FIG. 3 is an enlarged schematic view of a region E in FIG. 1;
FIG. 4 is a schematic diagram illustrating a moment principle of FIG. 1;
FIG. 5 is a schematic structural diagram illustrating jumping of a wafer to be cleaned according to an embodiment of the present disclosure; and
FIG. 6 is a flowchart illustrating a testing method for a semiconductor cleaning apparatus according to an embodiment of the present disclosure.

### DETAIL DESCRIPTION OF EMBODIMENTS

In order to make the objectives, technical solutions and advantages of the present disclosure clearer, the technical solutions of the present disclosure will be clearly and thoroughly described below in conjunction with specific embodiments of the present disclosure and the corresponding drawings. Apparently, the embodiments described herein are only part of the embodiments of the present disclosure, but are not all the embodiments. All other embodiments derived by those of ordinary skill in the art from the embodiments described herein without inventive work fall within the scope of the present disclosure.

In the embodiments of the present disclosure, the terms "first", "second" and like are used to distinguish the same or similar items having substantially the same functions and actions, are just used for clearly describing the technical solutions of the embodiments of the present disclosure, and should not be understood as indicating or implying relative importance or implicitly indicating the number of the indicated technical features.

In the embodiments of the present disclosure, "a plurality of layer" means two or more layers, and "a plurality of" means two or more, unless specifically limited otherwise. In the description of the present disclosure, it should be noted that the orientations or positional relationships indicated by the terms "up", "down", "front", "back", "inside", "outside" and the like are the orientations or positional relationships based on the drawings, and those terms are used simply for conveniently describing the present disclosure and simplifying the description, rather than indicating or implying that the device or element referred to must have a particular orientation or must be constructed and operated in a particular orientation, and therefore, those terms should not be considered as limitation to the present disclosure.

An existing hot phosphoric acid cleaning apparatus adopts an hot phosphoric acid etching solution which is prepared from concentrated phosphoric acid and deionized water (DIW); a boiling point of the etching solution rises with an increase of phosphoric acid concentration; water and phosphoric acid form an azeotrope; with continuous evaporation of water, water content decreases and the phosphoric acid concentration increases, such that the boiling point rises along with a decrease of the water content. Boiling of the hot phosphoric acid etching solution can cause a wafer to shake, such that the wafer may collide with a lifter to be easily scratched or broken. Therefore, the chemical solution needs to be kept in a non-boiling state in the hot phosphoric acid etching process.

A stable etching rate is very important to a manufacturing process of silicon nitride wafers, and key factors affecting the etching rate are water content (or phosphoric acid volume fraction), a reaction temperature, and a phosphoric acid replacement rate on wafer surfaces. The existing cleaning apparatus can already achieve stable flow and temperature, and adjustment and control of the volume fraction become very important. In order to increase available time of the apparatus and reduce time for acid replacement, a preheating method is generally adopted, that is, a phosphoric acid solution is heated to a certain temperature (e.g., 100°C) before acid replacement, and then is replenished to a reaction tank. As a temperature of the phosphoric acid solution in the reaction tank increases, moisture contained in the phosphoric acid solution keeps evaporating, and the phosphoric acid volume fraction increases accordingly. The phosphoric acid volume fraction may affect the etching rate, and further affect the etching effect; therefore, the phosphoric acid volume fraction needs to be kept within a certain range. During the acid replacement, the water in the phosphoric acid solution naturally evaporates to ensure that the phosphoric acid concentration meets requirements. Then, water is intermittently replenished to the phosphoric acid solution to balance the water consumed by evaporation and reaction, so as to maintain the phosphoric acid solution at a constant volume fraction, thereby controlling the etching rate well. However, due to different equipment configurations, mechanical structures may vary to a certain extent, and an airflow field of whole machine may also change, resulting in poor control of evaporation volume of liquid in the phosphoric acid solution and high difficulty in controlling water replenishment amount.

At present, the manual visual inspection is adopted to determine whether the water replenishment amount meets requirements, but the manual visual inspection has low detection accuracy of wafer jumping, which affects the etching effect. Moreover, the manual visual inspection involves a high risk factor

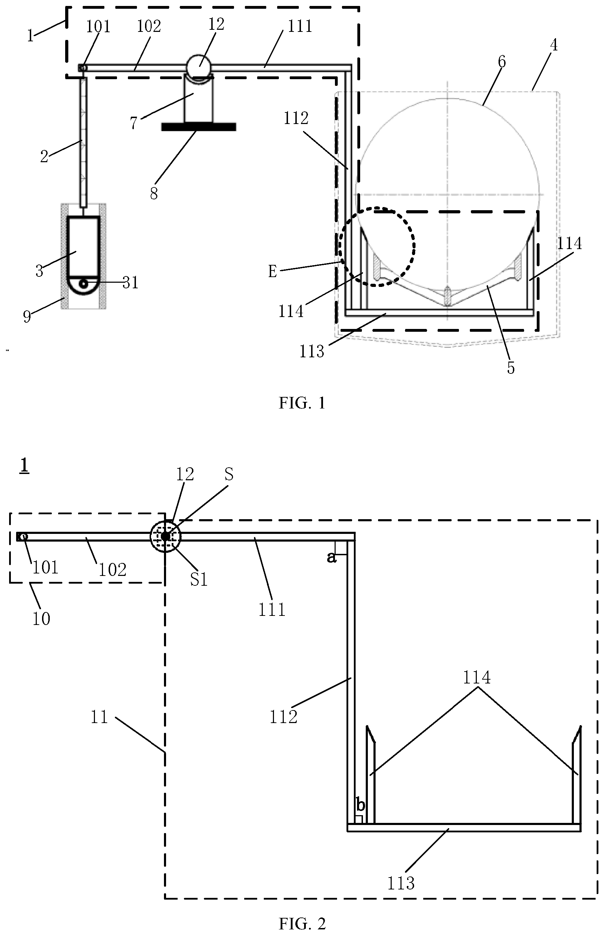

Based on the above, an embodiment of the present disclosure provides a testing device applied to a semiconductor cleaning apparatus, and the semiconductor cleaning apparatus includes a process tank 4, and a wafer 6 to be cleaned is disposed in the process tank 4. Referring to FIG. 1, the testing device includes: a testing balance mechanism 1, an elastic assembly 2, and a testing assembly 3, and two ends of the elastic assembly 2 are fixed to the testing balance mechanism 1 and the testing assembly 3, respectively; and the testing balance mechanism 1, the elastic assembly 2, the testing assembly 3, and the wafer 6 to be cleaned form a lever system.

One end of the testing balance mechanism 1 is connected to the elastic assembly 2, and the other end of the testing balance mechanism 1 is configured to support the wafer 6 to be cleaned in the process tank 4; the testing balance mechanism 1 is configured to change, in a case where the wafer 6 to be cleaned jumps, a deformation amount of the elastic assembly 2 based on the lever principle; and the testing assembly 3 is configured to measure the deformation amount of the elastic assembly 2.

The testing balance mechanism 1, the elastic assembly 2, the testing assembly 3, and the wafer 6 to be cleaned form the lever system. Before water is replenished to the process tank 4, the elastic assembly 2 and the testing assembly 3 are disposed at one end of the testing balance mechanism 1, and the wafer 6 to be cleaned is disposed at the other end of the testing balance mechanism, so that the lever system is in a moment-stable state. After water is replenished to the process tank 4, a boiling phenomenon is caused if a water replenishment amount is not appropriate; then, the wafer 6 to be cleaned is caused to jump, and a force applied by the wafer 6 to be cleaned to the testing balance mechanism 1 is changed. Based on the lever principle, the deformation amount of the elastic assembly 2 is accordingly changed, and the change of the deformation amount of the elastic assembly 2 is finally reflected in the testing assembly 3. Thus, whether the wafer 6 to be cleaned jumps may be determined from a change of test data from the testing assembly 3, so as to determine whether the water replenishment amount meets requirements to ensure that a concentration of a chemical solution in the process tank 4 is within an ideal concentration range and no boiling phenomenon is caused after water replenishment.

It should be noted that the phenomenon that the wafer 6 to be cleaned jumps when the chemical solution boils is also called wafer jumping, that is, after the chemical solution boils, the liquid pushes the wafer 6 to be cleaned to depart from an original support component and the wafer 6 to be cleaned jumps up and down within a certain range. That is, since the liquid pushes the wafer 6 to be cleaned to depart from the original support component after the chemical solution boils, the two ends of the testing balance mechanism 1 are not balanced, the deformation amount of the elastic assembly 2 is changed accordingly based on the lever principle, and whether the wafer 6 to be cleaned jumps can be determined from the change of the test data from the testing assembly 3.

Specific structures of the testing balance mechanism 1, the elastic assembly 2, and the testing assembly 3 are not limited as long as the testing balance mechanism 1, the elastic assembly 2, and the testing assembly 3 can perform corresponding functions.

In the testing device provided in the embodiment of the present disclosure, jumping of the wafer 6 to be cleaned is converted into measurable deformation of the elastic assembly 2 by cooperation of the testing balance mechanism 1, the elastic assembly 2, and the testing assembly 3, so that whether the wafer 6 to be cleaned jumps can be determined from the change of the test data from the testing assembly 3. In this way, adoption of the manual visual inspection can be avoided, so that personal safety issues can be prevented, and the risk factor can be reduced. In addition, the testing device is free from vapors in a process environment, and can greatly improve detection accuracy and efficiency of wafer jumping, thereby preventing the wafer from being scratched and broken, reducing wafer breakage rate, and also improving the etching effect.

For structure simplification and easy implementation, in some embodiments, as shown in FIG. 2, the testing balance mechanism 1 further includes: a rotatable assembly 12 and a testing balance assembly; the test balancing assembly includes a first part 11 and a second part 10; one end of the first part 11 is fixedly connected to the second part 10, and the other end of the first part 11 is disposed in the process tank 4 for supporting the wafer 6 to be cleaned; an end of the second part 10 which is not connected to the first part 11 is connected to the elastic assembly 2; and the rotatable assembly 12 is fixed at a connection position S1 of the first part 11 and the second part 10, and a contact point of the rotatable assembly 12 with the connection position S1 is a fixed point S. In other words, a position at which the first part 11 and the second part 10 are connected to each other is the connection position S1, the rotatable assembly 12 is fixedly connected at the connection position S1, and the contact point of the rotatable assembly 12 with the connection position S1 is the fixed point S.

The first part 11 is configured to rotate around the fixed point S in a case where the wafer 6 to be cleaned jumps; the rotatable assembly 12 is configured to be driven by the first part 11 to rotate around an axis of the rotatable assembly 12; and the second part 10 is configured to be driven by the first part 11 and the rotatable assembly 12 to rotate around the fixed point S, so as to change the deformation amount of the elastic assembly 2. That is, the fixed point S is on a rotation axis of the first part 11 and the second part 10, so that both the first part 11 and the second part 10 can rotate around the fixed point S.

Specific structures of the first part 11, the second part 10, and the rotatable assembly 12 are not limited and may be selected based on actual situations. Illustratively, the rotatable assembly 12 may include a structure such as an axle, a bearing, a coupling, or a gear. It should be noted that the rotatable assembly 12 may partially or integrally rotate when driven by the first part 11, which is not limited herein.

It should be noted that when the wafer 6 to be cleaned jumps, the first part 11 rotates around the fixed point S with small amplitude, which has a weak influence on moment; if the rotatable assembly 12 is not provided, the second part 10 hardly rotates to change the deformation amount of the elastic assembly 2, such that a test value from the testing assembly 3 does not change, resulting in a failure to detect the jumping of the wafer 6 to be cleaned. In view of this, according to the embodiment of the present disclosure, by providing the rotatable assembly 12, the small-amplitude rotation of the first part 11 around the fixed point S is amplified to the large-amplitude rotation of the rotatable assembly 12, and further drives the second part 10 to rotate to change the deformation amount of the elastic assembly 2, and the jumping of the wafer 6 to be cleaned is finally detected by the testing assembly 3.

In order to further simplify structure and reduce manufacturing difficulty, in some embodiments, as shown in FIG. 2, the first part 11 includes a power rod 111, a connecting rod 112, and a support member, which are connected in sequence; the support member includes a base 113 and a supporting part 114 disposed on the base 113, the base 113 is fixedly connected to the connecting rod 112, and the supporting part 114 is configured to support the wafer 6 to be cleaned; a first included angle a is formed between the power rod 111 and the connecting rod 112, and a second included angle b is formed between the connecting rod 112 and the base 113; the second part 10 includes a resistance rod 102; and the resistance rod 102 has one end connected to the power rod 111 and the other end connected to the elastic assembly 2.

A range of the first included angle a and a range of the second included angle b are not limited. Illustratively, the first included angle a and the second included angle b may be acute angles, right angles, or obtuse angles. FIG. 2 illustrates an example in which the first included angle a and the second included angle b are both right angles.

The number of supporting parts 114 is not limited; in order to reduce contact area with the wafer 6 to be cleaned as much as possible while ensuring supporting force, two supporting parts 114 may be provided to contact two opposite edges of the wafer 6 to be cleaned, respectively. Since the edges of the wafer 6 to be cleaned are curved surfaces, for reducing damage to the wafer 6 to be cleaned, upper surfaces of the supporting parts 114 are curved surfaces, and contact the edges of the wafer 6 to be cleaned. The wafer 6 to be cleaned may be vertically placed on the supporting parts 114, and the supporting parts 114 are vertically disposed and are perpendicular to the base 113. In order to improve cleaning efficiency, a plurality of wafers 6 to be cleaned may be disposed on the supporting parts 114. A structure of the base 113 is not limited. Illustratively, the base 113 may include a bottom rod or a bottom plate.

The power rod 111, the connecting rod 112, and the support member may be integrally formed or separately disposed, which is not limited herein. Illustratively, for reducing cost, the power rod 111 may be fixed to the connecting rod 112 by a fastener (e.g., a screw or a bolt), the connecting rod 112 may be fixed to the base 113 by a fastener (e.g., a screw or a bolt), and the base 113 and the supporting part 114 may be fixed to each other by a fastener (e.g., a screw or a bolt) or may be integrally formed.

The power rod 111 and the resistance rod 102 may be connected to each other by means of welding or by a fastener, or may be integrally formed, which is not limited herein.

The power rod 111, the fixed point S, and the resistance rod 102 may be disposed along a same straight line to reduce difficulty in design and manufacturing. An end of the resistance rod 102 which is connected to the elastic assembly 2 may be provided with a connecting hole 101 as shown in FIG. 1, and the resistance rod 102 is connected to the elastic assembly 2 through the connecting hole 101.

In some embodiments, the power rod 111 and the resistance rod 102 are integrally formed to simplify manufacturing process and reduce cost.

In some embodiments, in order to reduce structure complexity, referring to FIG. 2, the first included angle a and the second included angle b are both 90 degrees, that is, the power rod 111 and the connecting rod 112 are disposed perpendicular to each other, and the connecting rod 112 and the base 113 are disposed perpendicular to each other. However, the present disclosure is not limited thereto. In some other embodiments not illustrated by the drawings, only the first included angle a is 90 degrees or only the second included angle b is 90 degrees, which is also feasible and within the scope of the present disclosure.

In one or more embodiments, in order to support the rotatable assembly 12, referring to FIG. 1, the testing device further includes: a supporting portion 7 and a fixing plate 8; the supporting portion 7 is fixedly connected to the fixing plate 8, and includes a supporting surface (not labelled in FIG. 1) and a fixing surface (not labelled in FIG. 1) which are opposite to each other, and the fixing surface is in contact with the fixing plate 8.

The supporting surface of the supporting portion 7 mates with the rotatable assembly 12 to facilitate the rotation of the rotatable assembly 12. Illustratively, the supporting surface is provided with a groove for supporting the rotatable assembly 12. A portion of the rotatable assembly 12 which contacts the groove is a convex portion for matching the groove, which facilitates the rotation of the rotatable assembly 12 in the groove.

It should be noted that when the testing device is applied to a semiconductor cleaning apparatus, the fixing plate 8 may be disposed at a suitable position of the semiconductor cleaning apparatus. The testing device may be used in conjunction with the semiconductor cleaning apparatus, and is applicable to different models of semiconductor cleaning apparatuses.

In one or more embodiments, for easy implementation and cost reduction, the elastic assembly 2 includes a spring, and the testing assembly 3 includes a load cell. One end of the spring is connected to the resistance rod 102 through the connecting hole 101, and the other end of the spring is connected to the load cell.

In order to facilitate configuration of a mounting position of the load cell to adapt to different semiconductor cleaning apparatuses, in some embodiments, referring to FIG. 1, the testing assembly 3 further includes a chute 9, and the load cell is movable along the chute 9 before the mounting position is determined; after the mounting position is determined, the load cell is fixed to the chute 9; and the mounting position is a location of the load cell in a case where the testing balance mechanism 1 supports the wafer 6 to be cleaned in the process tank 4 and the lever system is in a balanced state.

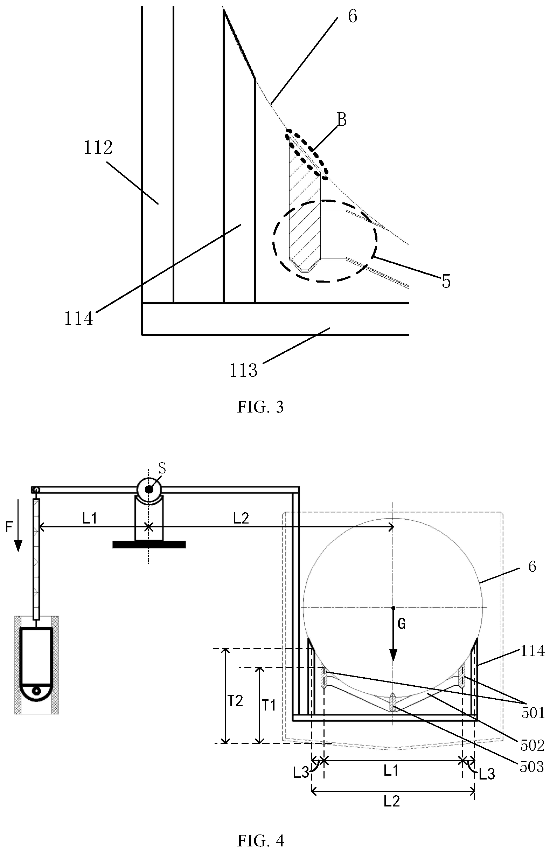

It should be noted that the load cell may be moved along the chute 9 in a process of determining the mounting position to change the deformation amount of the spring and thus generate an elastic force, so that the testing balance mechanism 1 can push up the wafer 6 to be cleaned, thereby causing a small gap between the wafer 6 to be cleaned and a lifter 5 with the wafer 6 to be cleaned not moving beyond a restriction range of the lifter 5; when the testing balance mechanism 1 replaces the lifter 5 to support the wafer 6 to be cleaned and the lever system formed by the testing balance mechanism 1, the spring, the load cell, and the wafer 6 to be cleaned is kept in a balanced state, a position of the load cell is determined as the mounting position. When a chemical solution concentration ratio test is performed on the semiconductor cleaning apparatus with the testing device, the load cell is always kept at the mounting position and is fixed; the deformation amount of the spring changes with the rotation of the second part 10 of the testing device, thereby changing a force applied to the load cell and further changing the test value from the load cell. FIG. 3 is an enlarged schematic view of a region E in FIG. 1, and referring to FIG. 3, the supporting part 114 of the testing balance mechanism 1 contacts the edge of the wafer 6 to be cleaned, and a small gap (a region defined by a black dashed circle B in FIG. 3) is formed between the lifter 5 and the edge of the wafer 6 to be cleaned. At this time, the lever system formed by the testing balance mechanism 1, the spring, the load cell, and the wafer 6 to be cleaned is in a moment-stable state (i.e., a balanced state), and meets F×L1=G×L2 , as shown in FIG. 4, with F representing a tension of the spring, G representing a gravity of the wafer 6 to be cleaned, and each of L1 and L2 representing a moment arm.

It should be noted that FIG. 4 illustrates an example in which the spring is in a stretched state, that is, the spring is stretched when the load cell is at the mounting position. Certainly, the spring may be in a compressed state when the load cell is at the mounting position, but since the spring is light, a fixing member needs to be additionally provided for keeping the spring in the compressed state, which causes complex structure design. Therefore, the structure shown in FIG. 4 is typically adopted.

After the mounting position is determined, the load cell may be fixed to the chute 9 by a fastener such as a screw through a fixing hole (labelled by 31 in FIG. 1) of the load cell. When the testing device is applied to a semiconductor cleaning apparatus, the chute 9 may be arranged and fixed at a suitable position of the semiconductor cleaning apparatus.

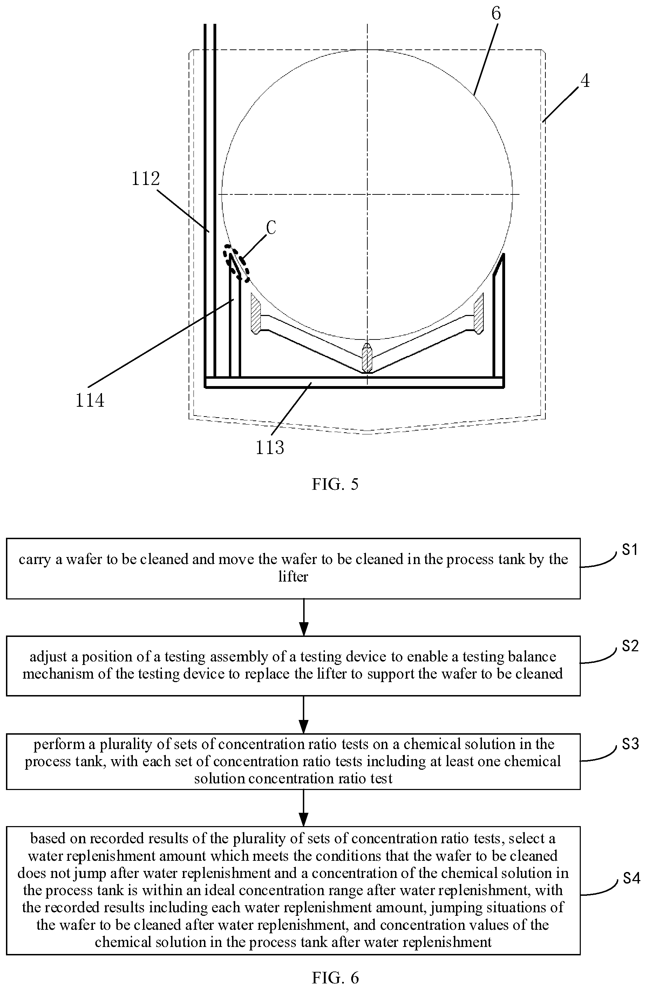

During a chemical solution concentration ratio test, if a water replenishment amount is too large, a concentration of the chemical solution greatly decreases, the boiling point lowers accordingly, and along with a temperature rise of the chemical solution, a boiling phenomenon can be easily caused and further cause the wafer 6 to be cleaned to jump; if the water replenishment amount is too small, along with the temperature rise of the chemical solution, moisture in the chemical solution becomes less and less, such that it is hard to maintain the concentration of the chemical solution at an ideal concentration value, which is not beneficial to control of the etching rate. Referring to FIG. 5, after the wafer 6 to be cleaned jumps, a gap (a region defined by a black dashed circle C in FIG. 5) is formed between the wafer 6 to be cleaned and the supporting part 114, so that a force applied to the testing balance mechanism 1 is changed, and a change of the deformation amount of the spring is further caused and is finally reflected in the load cell. Whether the wafer 6 to be cleaned jumps may be determined from a change of test data from the load cell, so as to determine whether the water replenishment amount meets requirements to ensure that the concentration of the chemical solution in the process tank 4 is within the ideal concentration range and no boiling phenomenon is caused after water replenishment.

An embodiment of the present disclosure further provides a semiconductor cleaning system, including: a semiconductor cleaning apparatus and the above testing device; and the semiconductor cleaning apparatus includes a lifter 5 and a process tank 4 provided therein with a chemical solution.

The lifter 5 is configured to carry a wafer 6 to be cleaned and move the wafer 6 to be cleaned in the process tank 4; and a distance between a contact position of the lifter 5 with the wafer 6 to be cleaned and a bottom of the process tank 4 is T1.

The testing device is configured to support, after the wafer 6 to be cleaned is placed in the process tank 4, the wafer 6 to be cleaned with the testing balance mechanism 1 which replaces the lifter 5; and a distance between a contact position of the testing balance mechanism 1 with the wafer 6 to be cleaned and the bottom of the process tank 4 is T2, and T2 is greater than T1. The testing device is further configured to detect whether the wafer 6 to be cleaned jumps after water is replenished to the process tank 4.

Specific structures of the lifter 5 and the process tank 4 can be found in the related technology, and will not be described here. A description of a structure of the testing device can be found in the above embodiments, and will not be given here. By keeping T2 greater than the T1, it can be ensured that the testing balance mechanism 1 pushes up the wafer 6 to be cleaned to form the small gap between the wafer 6 to be cleaned and the lifter 5. Referring to FIG. 4, the lifter 5 may include a carrier assembly with a V-shaped longitudinal section, the carrier assembly includes two carrier portions 501, a connecting portion 502, and a carrier base 503, the connecting portion 502 is configured to connect the carrier portions 501 to the carrier base 503, a distance between contact positions of the carrier portions 501 with the wafer 6 to be cleaned and the bottom of the process tank 4 is T1, as shown in FIG. 4; the testing balance mechanism 1 includes two supporting parts 114, a distance between contact positions of the supporting parts 114 with the wafer 6 to be cleaned and the bottom of the process tank 4 is T2, as shown in FIG. 4, and T2 is greater than T1. A distance L2 between the two supporting parts 114 is greater than a distance L1 between the two carrier portions 501; and a distance L3 between the carrier portions 501 and the supporting parts 114 may be defined based on actual situations.

The semiconductor cleaning system may further include other structures such as a concentration meter for measuring a concentration value of the chemical solution in the process tank 4.

The chemical solution is used for wet etching on a surface of the wafer 6 to be cleaned, thereby achieving cleaning; and the chemical solution may include a phosphoric acid solution.

The semiconductor cleaning system can detect wafer jumping based on the testing device, avoid adoption of the manual visual inspection, and improve detection accuracy of wafer jumping, thereby preventing the wafer from being scratched and broken while improving the etching effect.

An embodiment of the present disclosure further provides a testing method for a semiconductor cleaning apparatus, and the semiconductor cleaning apparatus includes a lifter 5 and a process tank 4. Referring to FIG. 6, the testing method for a semiconductor cleaning apparatus includes:
S1, carrying a wafer 6 to be cleaned and moving the wafer 6 to be cleaned in the process tank 4 by the lifter 5;
S2, adjusting a position of a testing assembly 3 of a testing device to enable a testing balance mechanism 1 of the testing device to replace the lifter 5 to support the wafer 6 to be cleaned;
S3, performing a plurality of sets of concentration ratio tests on a chemical solution in the process tank 4, with each set of concentration ratio tests including at least one chemical solution concentration ratio test; and
S4, based on recorded results of the plurality of sets of concentration ratio tests, selecting a water replenishment amount which meets the conditions that the wafer 6 to be cleaned does not jump after water replenishment and a concentration of the chemical solution in the process tank 4 is within an ideal concentration range after water replenishment, with the recorded results including each water replenishment amount, jumping situations of the wafer 6 to be cleaned after water replenishment, and concentration values of the chemical solution in the process tank 4 after water replenishment.

The chemical solution is used for wet etching on a surface of the wafer 6 to be cleaned, thereby achieving cleaning; the chemical solution may include a phosphoric acid solution, which has an ideal concentration range of 86% to 87% and a temperature range of 150°C to 170°C. A boiling point of the phosphoric acid solution varies at different concentrations. Illustratively, the boiling point of the phosphoric acid solution is 261°C at the concentration of 100%; and the boiling point of the phosphoric acid solution is 158°C at the concentration of 85%. The boiling point rises with an increase of the concentration.

By performing steps S1 to S4, the water replenishment amount meeting requirements can be obtained, so that adoption of the manual visual inspection can be avoided, detection accuracy of wafer jumping can be improved, the wafer can be prevented from being scratched and broken, and the etching effect can also be improved.

At step S3, the chemical solution concentration ratio test includes steps S31 to S34.

At S31, water is replenished to the process tank 4 under the condition that a water replenishment condition is met.

The water replenishment condition may be determined based on actual requirements, and is not limited herein.

At S32, whether the wafer 6 to be cleaned jumps is determined based on a percentage change in a test value from the testing assembly 3 of the testing device after current water replenishment.

At step S33, a test step after the current water replenishment is determined based on a determination result, with the test step after the current water replenishment including any one of a step of ending the current test, a step of performing a next chemical solution concentration ratio test, or a step of replacing the chemical solution in the process tank 4 and performing a next set of concentration ratio tests.

At step S34, a current water replenishment amount, a jumping situation of the wafer 6 to be cleaned after the current water replenishment, and a concentration value of the chemical solution in the process tank 4 after the current water replenishment are recorded.

By performing steps S31 to S34, the current water replenishment amount and the jumping situation of the wafer 6 to be cleaned after the current water replenishment can be obtained, so that whether the current water replenishment amount is appropriate can be determined based on the jumping situation of the wafer 6 to be cleaned.

In some embodiments, step S31 of replenishing water to the process tank 4 under the condition that the water replenishment condition is met includes:
if a difference between an ideal concentration of the chemical solution in the process tank 4 and an actual concentration of the chemical solution in the process tank 4 is within a range of a preset concentration difference, replenishing water to the process tank 4.

The ideal concentration of the chemical solution in the process tank 4 may be determined based on properties of a specific liquid included by the chemical solution. For example, if the chemical solution includes a phosphoric acid solution which may have an ideal concentration range of 86% to 87%, the ideal concentration of the phosphoric acid solution may be 86%, 86.5%, 87%, or the like. The actual concentration of the chemical solution in the process tank 4 may be measured by a concentration meter. The preset concentration difference may be selected as required. Illustratively, the range of the preset concentration difference may be (0, 0.15%], and the preset concentration difference may be 0.10%, 0.11%, 0.13%, 0.15%, or the like.

It should be noted that during a concentration ratio test of the phosphoric acid solution, a timing of water replenishment is when the actual concentration of the phosphoric acid solution is about to reach the ideal concentration of the phosphoric acid solution instead of when the actual concentration of the phosphoric acid solution already reaches the ideal concentration of the phosphoric acid solution. If water replenishment is started when the actual concentration of the phosphoric acid solution already reaches the ideal concentration of the phosphoric acid solution, the actual concentration of the phosphoric acid solution can easily exceed the ideal concentration of the phosphoric acid solution because it takes a certain time for the replenished water to diffuse in the process tank 4, that is, an influence of the replenished water on the concentration of the phosphoric acid solution delays to certain extent, and moisture in the phosphoric acid solution keeps evaporating during the delay. Therefore, water replenishment needs to be started when the actual concentration of the phosphoric acid solution is about to reach the ideal concentration of the phosphoric acid solution, thereby ensuring that the actual concentration of the phosphoric acid solution is equal to the ideal concentration for a while after water replenishment. If the ideal concentration of the phosphoric acid solution is 86% and the actual concentration of the phosphoric acid solution in the process tank 4 is 85.9%, the difference between the two concentrations is 0.1% which is within the range (0, 0.15%] of the preset concentration difference, that is, the water replenishment condition is met, so that water replenishment to the process tank 4 can be started.

In some embodiments, step S32 of determining whether the wafer 6 to be cleaned jumps based on the percentage change in the test value from the testing assembly 3 of the testing device after the current water replenishment includes steps S321 and S322.

At S321, a difference between an absolute value of the percentage change A1 in the test value from the testing assembly 3 after the current water replenishment and a preset percentage change A2 is determined, with A1= [(A - A0) / A0] ×100% , where A denoting the test value from the testing assembly 3 of the testing device after the current water replenishment, and A0 denoting a test value from the testing assembly 3 of the testing device before the current water replenishment.

It should be noted that when jumping of the wafer 6 to be cleaned occurs, the wafer 6 to be cleaned may jump up or jump down. Illustratively, taking a case where an elastic assembly 2 is in a stretched state when the wafer 6 to be cleaned is supported by the testing balance mechanism 1 as an example, when the chemical solution boils due to an excessive water replenishment amount in a chemical solution concentration ratio test, if the wafer 6 to be cleaned jumps up, A is less than A0 and A1 is less than zero; if the wafer 6 to be cleaned jumps down, A is greater than A0 and A1 is greater than zero.

The preset percentage change may be determined based on actual requirements. Illustratively, a range of the preset percentage change may be [18%, 25%]. Illustratively, the preset percentage change may be 18%, 20%, 22%, 25%, or the like.

At S322, if the difference is greater than or equal to zero, it is determined that the wafer 6 to be cleaned jumps, in which case the absolute value of the percentage change in the test value from the testing assembly 3 after the current water replenishment is greater than or equal to the preset percentage change; if the difference is less than zero, it is determined that the wafer 6 to be cleaned does not jump, in which case the absolute value of the percentage change in the test value from the testing assembly 3 after the current water replenishment is less than the preset percentage change.

In some embodiments, step S33 of determining the test step after the current water replenishment based on the determination result includes:
if the wafer 6 to be cleaned does not jump after the current water replenishment and the number of times of completed water replenishment does not reach a preset number of times of water replenishment, performing the next chemical solution concentration ratio test after a preset time period.

It should be noted that the completed water replenishment includes the current water replenishment; and the preset number of times of water replenishment is selected based on actual situations, and is, for example, 4 to 8.

Alternatively, step S33 of determining the test step after the current water replenishment based on the determination result includes: ending the current test if the wafer 6 to be cleaned does not jump after the current water replenishment and the number of times of completed water replenishment reaches a preset number of times of water replenishment.

Alternatively, step S33 of determining the test step after the current water replenishment based on the determination result includes: if the wafer 6 to be cleaned jumps after the current water replenishment, replacing the chemical solution in the process tank 4, and performing the next set of concentration ratio tests, with the current chemical solution concentration ratio test being an i^{th} chemical solution concentration ratio test in a current set of concentration ratio tests, the water replenishment amount of the i^{th} chemical solution concentration ratio test in the current set of concentration ratio tests being larger than a water replenishment amount of an i^{th} chemical solution concentration ratio test in the next set of concentration ratio tests, and i being a positive integer and meeting 1≤i<the preset number of times of water replenishment.

The flow of a water replenishment test is described below by taking a case where the preset number of times of water replenishment is 3, the ideal concentration of the phosphoric acid solution is 86%, the actual concentration of the phosphoric acid solution in the process tank 4 is 85.9%, and the range of the preset concentration difference is (0, 0.15%] as an example.

Since the difference between the ideal concentration of the phosphoric acid solution and the actual concentration of the phosphoric acid solution is 0.1% which is within the range of the preset concentration difference, the water supplementing condition is met, so that water replenishment to the process tank 4 may be performed for the first time with a water replenishment amount M1. Whether the wafer 6 to be cleaned jumps is determined after the first water replenishment.

If the wafer 6 to be cleaned does not jump after the first water replenishment and the water replenishment condition is met again after the first water replenishment, water replenishment to the process tank 4 is performed for the second time with a water replenishment amount M2; then, whether the wafer 6 to be cleaned jumps is determined after the second water replenishment. If the wafer 6 to be cleaned does no jump after the second water replenishment and the water replenishment condition is met again after the second water replenishment, water replenishment to the process tank 4 is performed for the third time with a water replenishment amount M3. Since the preset number of times of water replenishment is 3, water replenishment is not performed after the third water replenishment, and the current test is ended. Whether the wafer 6 to be cleaned jumps still needs to be determined after the third water replenishment. If the wafer 6 to be cleaned jumps after the second water supplement, the phosphoric acid solution in the process tank 4 is replaced, and the next set of tests are performed; and in the next set of tests, a first water replenishment amount may be M1, and a second water replenishment amount may be less than M2.

If the wafer 6 to be cleaned jumps after the first water supplement, the phosphoric acid solution in the process tank 4 is replaced, and the next set of tests are performed; and in the next set of tests, a first water replenishment amount is less than M1. Reference may be made to the above flow of the current water replenishment test for the flow of the next set of tests.

A plurality of sets of concentration ratio tests may be performed based on the above test flow, a test table is drawn, and for each set of tests, each water replenishment amount, the jumping situations of the wafer 6 to be cleaned after water replenishment, and the concentration values of the chemical solution in the process tank 4 after water replenishment are recorded. Finally, a set of water replenishment amounts (i.e., water replenishment process parameters for the phosphoric acid solution), which meet the conditions that the concentration of the chemical solution in the process tank 4 is within the ideal concentration range and no boiling phenomenon is caused after each water replenishment, is determined.

It should be noted that the terms "include", "comprise" or any other variation thereof are intended to indicate a non-exclusive inclusion, so that a process, method, article, or device, which includes a series of elements, does not only include those listed elements but also include other elements which are not explicitly listed, or the elements inherent in such process, method, article, or device. If there are no more limitations, limiting an element by "including a..." does not exclude the existence of other identical elements in the process, method, article, or device which includes the element.

The terms "one embodiment", "an embodiment", or "one or more embodiments" used in the present disclosure indicate that the specific features, structures, or characteristics described in conjunction with the embodiment(s) are included in at least one embodiment of the present disclosure. In addition, it should be noted that the term "in one embodiment" does not necessarily indicate one same embodiment.

What is described above is just the embodiments of the present disclosure, but is not intended to limit the present disclosure. Various modifications and changes may be made to the present disclosure by those of ordinary skill in the art. Any modification, equivalent replacement and improvement made within the spirit and principle of the present disclosure should be included in the scope of the appended claims of the present disclosure.

## Claims

1. A testing device, applied to a semiconductor cleaning apparatus comprising a process tank, a wafer to be cleaned being disposed in the process tank,
wherein the testing device comprises: a testing balance mechanism, an elastic assembly, and a testing assembly, and two ends of the elastic assembly are connected to the testing balance mechanism and the testing assembly, respectively; and the testing balance mechanism, the elastic assembly, and the testing assembly are configured to form a lever system together with the wafer to be cleaned;
one end of the testing balance mechanism is connected to the elastic assembly, and the other end of the testing balance mechanism is configured to support the wafer to be cleaned in the process tank;
the testing balance mechanism is configured to change, in a case where the wafer to be cleaned jumps, a deformation amount of the elastic assembly based on the lever principle; and
the testing assembly is configured to measure the deformation amount of the elastic assembly.

2. The testing device of claim 1, wherein the testing balance mechanism comprises: a rotatable assembly and a testing balance assembly;
the test balancing assembly comprises a first part and a second part; one end of the first part is fixedly connected to the second part, and the other end of the first part is disposed in the process tank for supporting the wafer to be cleaned; and an end of the second part which is not connected to the first part is connected to the elastic assembly;
the rotatable assembly is connected at a connection position of the first part and the second part, and a contact point of the rotatable assembly with the connection position is a fixed point;
the first part is configured to rotate around the fixed point in a case where the wafer to be cleaned jumps;
the rotatable assembly is configured to be driven by the first part to rotate around an axis of the rotatable assembly; and
the second part is configured to be driven by the first part and the rotatable assembly to rotate around the fixed point, so as to change the deformation amount of the elastic assembly.

3. The testing device of claim 2, wherein the first part comprises a power rod, a connecting rod, and a support member, which are connected in sequence; the support member comprises a base and a supporting part disposed on the base, the base is connected to the connecting rod, and the supporting part is configured to support the wafer to be cleaned; and a first included angle is formed between the power rod and the connecting rod, and a second included angle is formed between the connecting rod and the base; and
the second part comprises a resistance rod; and the resistance rod has one end connected to the power rod and the other end connected to the elastic assembly.

4. The testing device of claim 3, wherein the power rod and the resistance rod are integrally formed.

5. The testing device of claim 3, wherein the first included angle and/or the second included angle is 90 degrees.

6. The testing device of claim 1, further comprising: a supporting portion and a fixing plate; and
the supporting portion is connected to the fixing plate, and comprises a supporting surface and a fixing surface which are opposite to each other, the fixing surface is in contact with the fixing plate, and the supporting surface is configured to support the testing balance mechanism.

7. The testing device of claim 1, wherein the elastic assembly comprises a spring, and the testing assembly comprises a load cell.

8. The testing device of claim 7, wherein the testing assembly further comprises a chute, and the load cell is movable along the chute before a mounting position is determined; after the mounting position is determined, the load cell is fixed to the chute; and the mounting position is a location of the load cell in a case where the testing balance mechanism supports the wafer to be cleaned in the process tank and the lever system is in a balanced state.

9. A testing method for a semiconductor cleaning apparatus, wherein the semiconductor cleaning apparatus comprises a lifter and a process tank;
the testing method for the semiconductor cleaning apparatus comprises:
carrying a wafer to be cleaned and moving the wafer to be cleaned in the process tank by the lifter;
adjusting a position of the testing assembly of the testing device of any one of claims 1 to 8 to enable the testing balance mechanism of the testing device to replace the lifter to support the wafer to be cleaned;
performing a plurality of sets of concentration ratio tests on a chemical solution in the process tank, each set of concentration ratio tests comprising at least one chemical solution concentration ratio test; and
based on recorded results of the plurality of sets of concentration ratio tests, selecting a water replenishment amount which meets conditions that the wafer to be cleaned does not jump after water replenishment and a concentration of the chemical solution in the process tank is within an ideal concentration range after water replenishment, wherein the recorded results comprise each water replenishment amount, jumping situations of the wafer to be cleaned after water replenishment, and concentration values of the chemical solution in the process tank after water replenishment;
wherein the at least one chemical solution concentration ratio test comprises:
replenishing water to the process tank under the condition that a water replenishment condition is met;
determining whether the wafer to be cleaned jumps based on a test value from the testing assembly of the testing device after current water replenishment;
determining a test step after the current water replenishment based on a determination result, the test step after the current water replenishment comprising any one of a step of ending the current test, a step of performing a next chemical solution concentration ratio test, or a step of replacing the chemical solution in the process tank and performing a next set of concentration ratio tests; and
recording a current water replenishment amount, a jumping situation of the wafer to be cleaned after the current water replenishment, and a concentration value of the chemical solution in the process tank after the current water replenishment.

10. The testing method of claim 9, wherein replenishing the water to the process tank under the condition that the water replenishment condition is met comprises:
in response to a difference between an ideal concentration of the chemical solution in the process tank and an actual concentration of the chemical solution in the process tank being within a range of a preset concentration difference, replenishing the water to the process tank.

11. The testing method of claim 9, wherein determining whether the wafer to be cleaned jumps based on the test value from the testing assembly of the testing device after the current water replenishment comprises:
determining a difference between an absolute value of a percentage change A1 in the test value from the testing assembly after the current water replenishment and a preset percentage change A2, wherein A1 = [(A - A0) / A0]×100%, where A denotes the test value from the testing assembly of the testing device after the current water replenishment, and AO denotes a test value from the testing assembly of the testing device before the current water replenishment; and
in response to the difference being greater than or equal to zero, determining that the wafer to be cleaned jumps; and in response to the difference being less than zero, determining that the wafer to be cleaned does not jump.

12. The testing method of claim 9, wherein determining the test step after the current water replenishment based on the determination result comprises:
in response to a case where the wafer to be cleaned does not jump after the current water replenishment and a number of times of completed water replenishment does not reach a preset number of times of water replenishment, performing the next chemical solution concentration ratio test after a preset time period;
or in response to a case where the wafer to be cleaned does not jump after the current water replenishment and a number of times of completed water replenishment reaches a preset number of times of water replenishment, ending the current test;
or in response to a case where the wafer to be cleaned jumps after the current water replenishment, replacing the chemical solution in the process tank, and performing the next set of concentration ratio tests; wherein the current chemical solution concentration ratio test is an i^{th} chemical solution concentration ratio test in a current set of concentration ratio tests, a water replenishment amount of the i^{th} chemical solution concentration ratio test in the current set of concentration ratio tests is larger than a water replenishment amount of an i^{th} chemical solution concentration ratio test in the next set of concentration ratio tests, and i is a positive integer and meets 1≤i<the preset number of times of water replenishment.
